# EUROPEAN PATENT APPLICATION

(11) **EP 4 647 782 A1**
(43) Date of publication of application: **12.11.2025**
(21) Application number: 24175230.2
(22) Date of filing: 10.05.2024
(51) Int. Cl.: G01R 31/327, B60L 53/00

(54) **METHOD AND SYSTEM FOR DETECTING WELDED CONDITION OF POWER CONTACTS IN ELECTRIC VEHICLE SUPPLY EQUIPMENT**

(71) Applicant: Siemens Aktiengesellschaft, 80333 München (DE)
(72) Inventor: MHATRE, Kalpesh, 400053 Mumbai, Maharashtra (IN); SCHALLING, Rudi, 04229 Leipzig (DE)
(74) Representative: Patentanwaltskanzlei WILHELM & BECK

(57) **Abstract**

Disclosed is a method (600) and a system for determining a welded condition of power contacts (110, 112) in an Outgoing Coil (OGC) within an Electric Vehicle Supply Equipment (EVSE) (102). The method (600) comprises initiating a condition verification process based on a set of predefined conditions. Upon completion of the condition verification process, a voltage pattern recognition process is executed to generate a voltage pattern by superimposing voltage pulses onto a power circuit of the EVSE. The method further comprises capturing an outlet voltage influenced by the voltage pulses superimposed on the power circuit. The method further comprises determining a welding status of the power contacts based on the captured outlet voltage. The method further comprises controlling an operational state of an associated charging outlet of the EVSE based on the determined welding status of the power contacts corresponding thereto.

## Description

The present disclosure relates generally to electric vehicle (EV) charging systems, and more particularly to a method and a system for detecting a welded condition of power contacts in an Electric Vehicle Supply Equipment (EVSE).

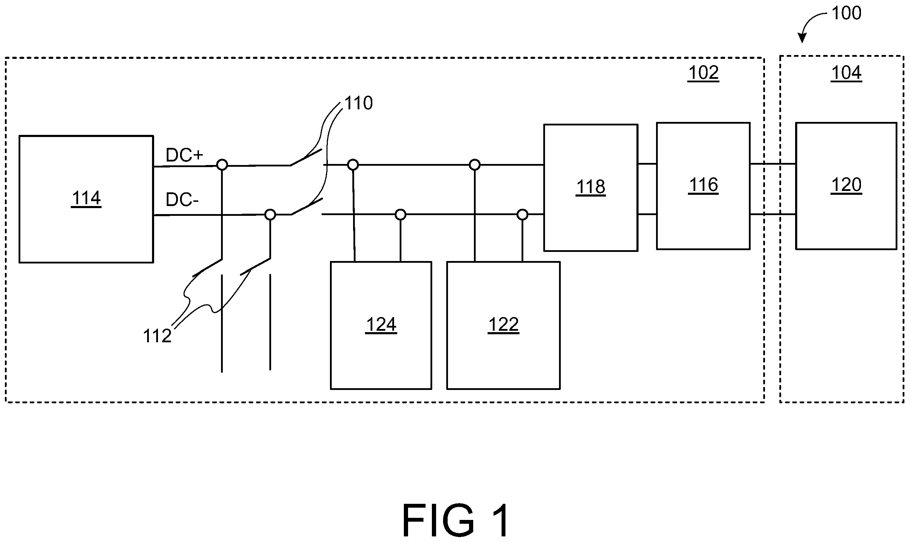

In electric vehicle supply equipment (EVSE) designed for direct current (DC) charging stations, often high voltage DC contactors or relays, hereafter referred to as outgoing coils (OGC), are utilized. FIG 1 illustrates a schematic of a DC power circuit 100 including an EVSE 102 in connect with an electric vehicle (EV) 104. The schematic depicts key components which are often found in the DC power circuit 100, for high power charging station. As illustrated, the EVSE 102 includes a first switch (Switch 1) 110, which is an OGC contactor/relay (OGC coil). The EVSE 102 also includes a second switch (Switch 2) 112 of similar type used for power switching for connection between neighbouring power converter(s) group, which are hereafter referred to as power switching coils (PSC). The first and second switches 110, 112 are found present in high voltage power circuit connected in between power converter(s) 114 on one side, and a DC charging gun 116 on other side, sometimes, optionally, via electromagnetic interference (EMI) filters 118. Further, the DC charging gun 116 is connected to Electric vehicle (EV) batteries 120 in the EV 104.

In the DC power circuit 100, the first and second switches 110, 112 are switched between open and close contact states by providing command from high level controller or programmable logic controller in various DC charging phases as described in IEC 61851-23, like (i) Cable Check, (ii) PreCharge, and (iii) Power Delivery. The request from initiating the message sequence as per DIN SPEC 70121 and ISO 15118 standards are initiated by Electric vehicle Communication controller (EVCC) which are decoded by Supply equipment communication controller (SECC), and then may be passed on to high level controller present in the EVSE 102 to decide control over switchgears and the power converters 114 including states of the first and second switches 110, 112 which are present inside the EVSE 102.

In particular, the EVSE 102 conveys via SECC to EVCC the available state of DC outlet which can be 'READY' or 'NOT READY' before the beginning of the charging session. The DC charging can only begin when DC outlets are in 'READY' state. Some of the important interlocks for this are as follows: (a) voltage transducer 122 reports voltage <60V and the readings from it are plausible; (b) insulation monitoring device (IMD) 124 reports insulation level at DC output side in the EVSE 102 as OK, where the IMD 124 is continuously monitoring insulation level at high voltage dc output side before and during charging; and (c) the first and second switches 110, 112 are in OFF state, and their power contacts are not welded.

During the cable check phase, insulation checks are performed by the EVSE 102 for detecting valid insulation levels between DC+, DC- and power earth (PE). Thereafter as per IEC standard, the first and second switches 110, 112 are closed and a voltage is impressed by the EVSE 102 at the charging gun 116 using the power converters 114 inside it, detected by the voltage transducer(s) 122 present in the EVSE 102 at side of the charging gun 116. After the expected voltage is reached, the EVSE 102 provides OFF command to the power converters 114 and may switch off/open the first and second switches 110, 112 with OFF command to them via high level controller/PLC inside the EVSE 102. In some designs of the EVSE 102, the SECC may also function as high-level controller if it has sufficient I/O driving and software capabilities in it.

During pre-charge phase, the EVCC (part of the EV 104) communicates to the SECC (part of the EVSE 102) a target voltage which is equal to present EV battery voltage and target current (less than 2A). The SECC decodes the messages coming from the EVSE 102 using DIN 70121/ISO 155118 standard and thereafter transmits the target voltage to high level controller (part of EVSE) which thereby switches ON (closes) the switches 110, 112 and powers ON the power converter(s) 114 directly connected to the switches 110, 112 until the target voltage is reached. After the end of successful pre-charge state, the switches 110, 112 are not switched OFF by higher level controller.

During power delivery phase, the state of the switches 110, 112 in DC+ and DC- circuit is required to be in closed state and the command to them are not withdrawn from pre-charge phase until end of power delivery phase which can be due to normal stop initiated by the EVSE 102 or the EV 104 or due to Error/Emergency stop initiated by the EVSE 102 or the EV 104. In order to meet the Emergency Stop requirements of IEC61851-23 standard, the switches 110, 112 may be required to be opened within 30msec. Due to this timing constraints, additional safety interlocks in the energizing coil circuit of OGC coils may be included by EVSE manufacturer evaluated by redundant hardware controller inside the EVSE 102 which allows the switches 110, 112 to close only if charging state evaluated by hardwired Control Pilot line is in Bx or Cx state. The definition of these charging states over control pilot (CP) wire which is part of DC charging cable is provided in IEC 61851-1 standard.

Due to space constraints, the switches 110, 112 found in the EVSE 102 are required to be compact in size which places a limit on their making and breaking capacity. They are normally switched between open and close position at lower switching current to enhance their switching cycles. Also, they need to be suitably designed for about 1000Vdc application. With all these requirements, the switches 110, 112 in OGC position are found in market to be of single pole type which would mean that the coils and power contacts are separate for DC+ and DC- circuit side.

Generally, the mechanical switches used in OGC position are also used in other applications, e.g., inside EV as disconnection device. The construction of these switches is often found to have its power contacts hermetically sealed in an enclosure. This makes it a challenge to the manufacturer to accurately obtain the status of power contacts. Unlike conventional contactors found in low voltage application, wherein an auxiliary switch (mechanical switch) is mounted on same shaft which changes position based on states of power contacts, the auxiliary switches normally used in OGC position use different technique of reed switch for indication of state of power contacts. The reed switch works on basis of presence of magnetic fields around it and the contacts of the reed switch has very low voltage and power handling capacity which often fails to indicate the correct state of power contacts. In some designs, the manufacturer of DC contactor/relay does not include reed switch or auxiliary switches in their design. Combinations of power contact state and reed switch/auxiliary switch state and coil command possible are shown in Table 1 below.

**Table 1: Possibilities with Power contact and Reed switch state and commands**

| **Possibility number** | **Coil Command** | **Power contact state** | **Reed switch state (optional)** | **Observation** |
|---|---|---|---|---|
| 1 | Open | Open | Open | Ok, normal |
| 2 | Open | Open | Close | Feedback fault |
| 3 | Open | Close | Open | Welded, fbk absent |
| 4 | Open | Close | Close | Welded, fbk available |
| 5 | Close | Open | Open | Feedback fault |
| 6 | Close | Open | Close | Pwr path open |
| 7 | Close | Close | Open | Feedback fault |
| 8 | Close | Close | Close | Ok, normal |

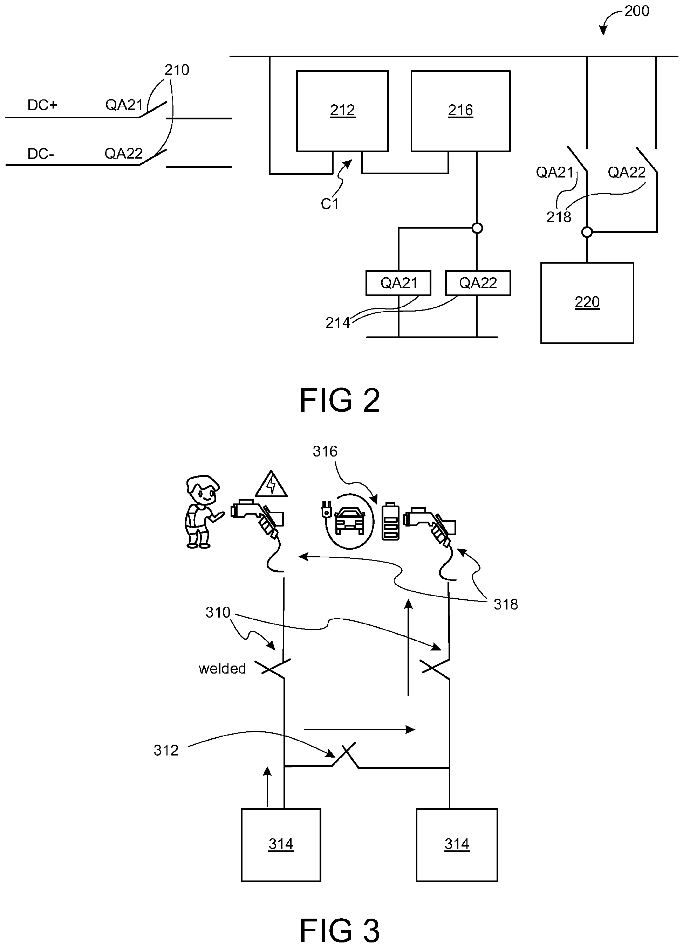

Referring to FIG 2, illustrated is a schematic showing various components/parts of OGC, which is a high voltage DC contactor (as represented by reference numeral 200). As shown, the DC contactor 200 includes a power part 210 (QA21 for DC+ and QA22 for DC-) responsible for the actual switching of high voltage direct current necessary for EV charging. Control of the contactor is managed by a controller 212 (for digital output) which sends commands (C1) to a coil 214 (part of the DC contactor/relay), influencing the open and close actions of the power part. The DC contactor 200 may also include a hardwired interlock 216, which functions as a safety feature ensuring that the contactor operates within safe parameters, preventing any inadvertent engagement that could lead to hazardous conditions, and to augment the safety measures, particularly when multiple contactor units are interconnected within the EVSE. Further, the DC contactor 200 includes a reed switch 218 (part of the DC contactor/relay), designed to provide feedback about the status of the power contacts. The reed switch 218 operates based on the magnetic fields generated when the coil part 214 is energized, indicating whether the contacts are in an open or closed state. This feedback utilized by a controller 220 (for digital input), allowing the EVSE system to monitor and verify the operational status of the contactor accurately.

It should be noted that in some cases, the OGC manufacturer may omit or not offer any auxiliary indication (i.e., position 5 contact may not be present). In case of auxiliary/reed switch not being a part of design, necessitates the need for detecting the state of power contacts based on other techniques comprising of hardwired and/or software methods in EVSE. If the OGC manufacturer supplies the auxiliary switch (i.e., the reed switch 218 in FIG 2), then this auxiliary switch is normally connected to the controller 220 of higher-level controller/PLC. The commands to OGC are controlled by the controller 212 of higher-level controller/PLC. It is expected that the power contact state mirrors the command from higher level controller/PLC and then the reed switch states mirror the power contact states with short delay of few milliseconds. This is shown in Condition#1 and #8 as depicted in Table 1. This can be considered as normal or expected state of operation of the OGC.

However, in some cases, the system may face a problem of uncertainty of state of power contacts with auxiliary switch feedback absent. This occurs in all the abnormal conditions in case OGC manufacturer does not provide any auxiliary feedback by means of mechanical contact or reed switch in control circuit. Here, the higher-level controller is left to assume that the power contact states of OGC always mirrors the command provided to coil part of OGC. In case there is no hardware or software method employed to detect the abnormal operation of OGC which presents a considerable safety risk when the EVSE hardware design comprises of more than one DC outlets with sharing of power converter groups which has co-existence of OGC and PSC together. There could be a short circuit between two DC outlets connected to different EV batteries operating at different voltage levels. This may cause physical or property damage at EVSE side as well as EV side.

In other cases, the system may face another problem of power contacts state following command, but auxiliary switch generating false positive. This problem may occur when the manufacturer has provided auxiliary switch (normally reed type) as part of design along with power contacts and energizing coil of OGC. In condition#2 (of Table 1), the higher- level controller needs power contacts open and thereby de-energizes the coil part of OGC to achieve this. However, even after extended monitoring delay, the auxiliary/reed switch is stuck and provides close feedback for OGC. Hence, the higher-level controller assumes that the power contacts are stuck or welded, however in reality it is a faulty design of reed switch which is the causing the problem. This is a case of false-positive in which the higher-level controller logs a feedback fault or estimation that the welding has occurred of power contacts of OGC and thereby the outlet remains out of order until the feedback is aligned with the command which in-turn creates a downtime and revenue loss for the client. It has also been observed in chargers deployed in field that the auxiliary switch (in form of reed switch) self-heals over an uncertain amount of time and then the DC outlet is READY again for EV charging. The repeated nature of this fault necessitates to put the entire charger in maintenance mode and order service from EVSE manufacturer. However, during the service it is found that the OGC power contacts are responding in correct manner as expected with respect to commands issued to coil part of it and hence the power part and controlling part of the OGC is in OK state. This increases the fault troubleshooting time of service personnel as the next suspicion arises on some wiring issues in charger or some other software bug may be present. It remains uncertain for long period of time whether OGC device is at fault. Moreover, some users may still point this out as quality issue in OGC coils and in warranty period demand the EVSE manufacturer to change the OGC with new one.

Further, in condition#7 (of Table 1), the higher-level controller needs power contacts closed and thereby energizes the coil part of OGC in order to achieve this. However, even after extended monitoring delay, the auxiliary/reed switch provides open feedback for OGC, even though the power contacts have in- reality closed as expected. Again, the suspicion goes on auxiliary feedback control circuit wire break issues. The user may then schedule frequent maintenance shutdowns in response to repeated events owing to this false positive nature generated by auxiliary/reed switch of OGC to recheck all the control wiring for continuity or breaks in circuit wiring which increases downtime of charger.

In still other case, the system may face problem of auxiliary switch state following command; however, power contacts being mis-aligned from command. This problem involves power contacts not responding to command to OGC and denotes the actual malfunctioning of OGC device or wiring errors in the EVSE which necessitates shutdown of charger or outlet and attention of service personnel to identify and rectify/repair the cause of problem so that the DC outlets are in READY state again. In condition#6 (of Table 1), the higher-level controller needs power contacts closed and thereby energizes the coil part of OGC. The auxiliary/reed switch provides close feedback for OGC. However, the power contacts are still in open state and an incorrect evaluation is done wherein the higher-level controller assumes that there is no problem with OGC. The issue gets discovered during cable check phase of EV charging wherein the voltage output of converters is not equal to the reading of voltage from the transducer located at another end of OGC. Hence, an early detection was not possible, and this results in zero power failed charging session without prior intimation of failure. The effect is that end-user (EV driver) is not satisfied as the charger was shown in healthy state before end-user plugged in the charging cable to own EV outlet.

Further, in condition#3 (of Table 1), the higher-level controller needs power contacts open and thereby de-energizes the coil part of OGC. The auxiliary/reed switch provides open feedback for OGC. However, the power contacts are still in closed/stuck state which is also known as welded state. The higher-level controller has failed to detect this condition which is serious issue. It is of utmost importance for EVSE manufacturer to detect this condition as soon as possible and to ensure that this DC outlet is kept in out-of-order state and to facilitate replacement of the DC contactors/relays as a service measure.

The detection of welded power contact of OGC becomes particularly important when the EVSE has multiple DC outlets connected to different power converter groups coupled by Power switching coils (PSC). In this constellation, software-based interlocking is usually done to ensure all OGC and PSC do not close at the same time as it may cause potential short circuit between the two EV batteries which would be at different voltage levels. Another safety hazard arises that dangerous voltages might be present on charging gun whose DC outlet is not in use when another DC outlet is in charging state and OGC power contact has been welded.

FIG 3 depicts one such safety risk possibility in an EVSE which has multiple DC outlets having sharing possibilities of group of converters for each of the DC outlet. In particular, FIG 3 depicts safety risks associated with welded power contacts of Outgoing Coils 310 in Electric Vehicle Supply Equipment (EVSE) that features multiple DC outlets. In such setups, each outlet, connected to various groups of power converters 314, can lead to critical situations if not managed correctly. The diagram highlights a typical arrangement where an electric vehicle 316 is connected via a charging gun 318, illustrating the flow of power through the Outgoing Coil 310 and Power Switching Coil 312.

This arrangement requires management to prevent simultaneous closure of all OGCs 310 and PSCs 312, as this could result in a short circuit between two EV batteries operating at different voltage levels. Such a situation not only poses a risk of physical and property damage but also introduces the hazard of dangerous voltages being present on the charging gun 318 of an unused DC outlet, particularly if the OGC power contact at that outlet is welded, indicating a failure to open despite command.

To summarize the problem(s), the outgoing coils are devices which are contactors and/or relays and are located at DC outlet side output before DC charging gun in an EVSE for EV charging application. This OGC device is typically a bought-out component which comprises of coil part, power contact part and auxiliary contact part. However, most suppliers optionally provide an auxiliary contact with help of which one can typically monitor open/close state of power contacts of OGC device. At present, there is a lack of visibility and/or missing reliable detection technique on whether the command from controller for opening/closing of the power contacts is properly aligned with the actual state of power contacts of OGC. This is mainly caused because of unreliable and/or mis-aligned states compared to power contacts or entirely missing auxiliary contact issues. This may result in safety issues in scenarios of actual welding of power contacts of OGC when command from high level controller is absent, especially in EVSE with multiple DC outlets having power converter groups connected to individual DC outlets and used on power sharing principles within more than one DC outlets using one or more power switching coils between these converter groups.

There are some known techniques which have been employed in the art to mitigate these issues. For instance, the similar type of high voltage DC contactor is found in many of the EVSE and EV. In EVSE, they are found in OGC and PSC positions; whereas in EV, this type of contactor is found connected between DC charging outlet at one end on the EV body and connected to live DC batteries at another end. Inside EVSE, there are several methods employed for detection of power contacts welded state of OGC. However, each of them has their own sets of limitations and demerits.

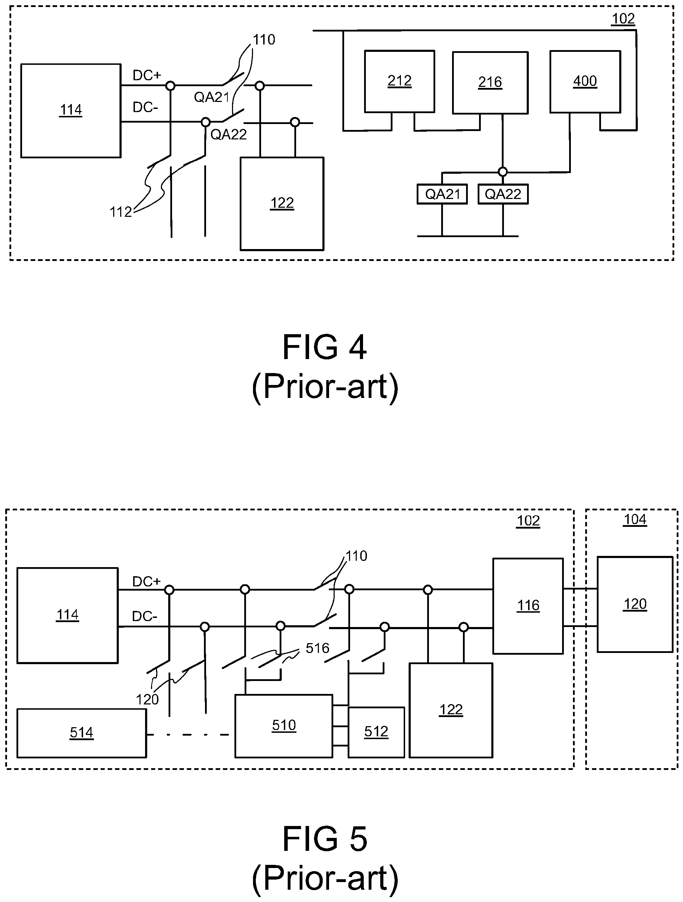

In one existing solution, as illustrated in FIG 4, an additional controller 400 (for digital output) from higher level controller (as part of the EVSE 102) is wired in the coil circuit. Whenever the condition exists, the power converters 114 directly connected to OGC are available and there is no EV connected to other end of OGC at charging gun side, then this additional output is closed and then the power converters 114 are started with minimum high voltage they can provide with minimum current limit issued to them. Difference between maximum output voltage reported by the power converters 114 and the reading from voltage transducer (not shown in FIG 4) is compared and if it is found within threshold for few seconds, then the next step is additional digital output is switched off from higher level controller. After this, there should be near to zero voltage reading from voltage transducer else it is assumed by EVSE that OGC has any one or both power contacts welded and keep the outlet out-of-order in maintenance mode until it has been acknowledged by the user from interface touch screen on charger or through backend connection via internet cloud and re-test has been passed.

However, this technique has multiple limitations/de-merits with regards to welding detection of power contacts of the OGC. It introduces additional software complexity by requiring control of converters when no charging session is active. The charging outlet is to be forced out-of-order during this power self-test procedure to detect welding. It needs to be ensured that the charging gun is returned to EVSE outlet holder and not connected to EV before performing this power self-test. The converters in the group must be ready and available for welding test, for example, if converters connected to OGC are sourcing power to another dc outlet or there is emergency stop active for EVSE, then the welding test cannot be performed and is blocked. It also needs to be ensured that the digital output from higher level controller and the associated extra coil added in circuit are in OFF states and not malfunctioning after welding test is done else it bypasses the other closing circuit hardwired interlocks which may be crucial for EV charging process. The voltage detected by transducer in case of single power contact (DC+ or DC-) actual welding is floating voltage. The threshold for this floating voltage (which can be considered not as false positive for welding detection of power contact of OGC) cannot be determined accurately by means of calculation and therefore needs to be found trial and error basis and hence reduces the overall robustness of the solution employed.

In another existing solution, as illustrated in FIG 5, additional digital output from higher level controller (part of the EVSE 102) to force close the OGC is not required. However, a custom design circuit is present, including a low voltage inducer 510 with corresponding low voltage power supply 512. The low voltage inducer 510 is connected to a higher-level controller 514 via a communication bus. The low voltage inducer 510 may be found in form of custom circuit with low-cost micro-controller. Communication soft signals transmitted from the low voltage inducer 510 to the higher-level controller 514 could be (a) states of its controlled relays indicated by switches (relays) 512, (b) voltage value presently injected from it, and (c) report of test completion for welded check of power contact of the OGC. Herein, when begin test command is issued and other software interlocks are OK (there is no other device which is injecting voltage in the OGC DC+/DC- circuit and the higher-level controller 514 has issued open commands to the OGC), the low voltage inducer 510 first injects a low voltage (like 24V dc) in DC+ circuit and checks if it is received back from measurement line at other end of the OGC. Then similar injection is done.

This technique has advantage that the power contact which has been welded of OGC (such as, switch 110 in FIG 5) can be found out, whether it is in DC+ circuit or DC- circuit or both. Regardless of welding, this test needs to be repeated at several intervals to ensure that welded state of power contact of OGC is obtained consistently. That said, this solution also has multiple limitations/demerits with regards to welding detection of power contacts of OGC. It requires additionally hardware and relays and wiring to be introduced in main power circuit which increases overall cost of charger for adding feature of welding detection of OGC. The relays added for low voltage injection circuit do not contribute to current flow, however their insulation levels are required to be much higher equal to the charger insulation level as they are introduced in power circuit, which increases their cost. Additional safety interlocks are required in hardware circuit to ensure that the low voltage and high voltage do not get switched ON at same time, else there would be internal product damages inside charger. Also, these hardware changes are difficult to perform in existing field installed chargers due to complexity and high efforts required for the same. Further, the presence of micro-controller in this solution for welding detection sequence handling procedures, increases complexity for bug fixes and regular firmware updates and including them in cyber security hardening design.

The present invention seeks to address these issues by providing a software-based measure for detection of states of welded OGC power contacts without relying on auxiliary/reed switch in the event when the dc outlet system is in idle state, i.e., power converters directly connected to OGC are in OFF state and when no EV has been connected to other end of OGC. The present invention provides a software based solution to detect welded state of power contacts of high voltage relay based on pulses generated by IMD in DC electric vehicle supply equipment (EVSE). In particular, the present invention describes software algorithm which acts based on distinguishing voltage pattern which is observed by interaction of IMD and power converters in group (converter group) in event of DC+, DC- or both power contacts of OGC are welded. The present invention solves the technical problem of detection of welding of power contacts of OGC without relying on its auxiliary/reed switch indication but utilizes a designed software algorithm with existing available components in EVSE.

The object of the present invention is achieved by a method for determining a welded condition of power contacts in an Outgoing Coil (OGC) within an Electric Vehicle Supply Equipment (EVSE). The method comprises initiating a condition verification process in an EVSE controller based on a set of predefined conditions. The method further comprises executing, by the EVSE controller, upon completion of the condition verification process, a voltage pattern recognition process to generate a voltage pattern by superimposing voltage pulses onto a power circuit of the EVSE via an insulation monitoring device. Herein, the voltage pattern is representative of an insulation state of the power contacts. The method further comprises capturing, by a voltage transducer, an outlet voltage influenced by the voltage pulses superimposed on the power circuit and transmitting the captured outlet voltage to the EVSE controller. The method further comprises determining, by the EVSE controller, a welding status of the power contacts based on the captured outlet voltage. The method further comprises controlling an operational state of an associated charging outlet of the EVSE based on the determined welding status of the power contacts corresponding thereto.

In one or more embodiments, the method also comprises determining, by the EVSE controller, a moving average value (MAV) of the outlet voltage based on the captured outlet voltage. The method further comprises comparing, by the EVSE controller, the determined MAV of the outlet voltage against a first predefined threshold value.

In one or more embodiments, the method also comprises comparing an instantaneous outlet voltage from the voltage transducer against a second predefined threshold value. Herein, the second threshold value is higher than the first threshold value.

In one or more embodiments, the method further comprises classifying, by the EVSE controller, the voltage pattern as one of abnormal, normal, or undefined. Herein, the voltage pattern is classified as the abnormal when either the computed MAV of the outlet voltage exceeds the first predefined threshold value or the instantaneous outlet voltage exceeds the second predefined threshold value, the voltage pattern is classified as the normal when neither the computed MAV of the outlet voltage exceeds the first predefined threshold value nor the instantaneous outlet voltage exceeds the second predefined threshold value, and the voltage pattern is classified as the undefined when there is variation in capturing of the outlet voltage.

In one or more embodiments, the method further comprises executing multiple instances of the voltage pattern recognition process. Herein, the welding status of the power contacts is confirmed based on consecutive instances of the voltage pattern recognition process exceeding a predefined count provide the voltage pattern being classified as the abnormal.

In one or more embodiments, the method further comprises, upon completion of the condition verification process, enabling a delay mechanism in the EVSE controller. The delay mechanism comprises a timer that delays the voltage pattern recognition process, to allow for the stabilization of a power circuit state.

In one or more embodiments, the set of predefined enabling conditions comprises one or more of an absence of an electric vehicle (EV) connected to the EVSE, presence of an open command to the OGC, the insulation monitoring device and the voltage transducer being in a ready state.

In one or more embodiments, the voltage pattern is generated by the insulation monitoring device utilizing a DC superimposition principle on the power circuit.

The object of the present invention is also achieved by a system comprising one or more processing units and a memory unit communicatively coupled to the one or more processing units. Herein, the memory unit comprises a weld detection module stored in the form of machine-readable instructions executable by the one or more processing units, wherein the weld detection module is configured to perform aforementioned method steps for detecting a welded condition of power contacts in an Outgoing Coil (OGC) within an Electric Vehicle Supply Equipment (EVSE).

The object of the present invention is further achieved by a computer program product, having machine-readable instructions stored therein, that when executed by the one or more processing units, cause the one or more processing units to perform aforementioned method steps.

Still, other aspects, features, and advantages of the invention are readily apparent from the following detailed description, simply by illustrating a number of particular embodiments and implementations, including the best mode contemplated for carrying out the invention. The invention is also capable of other and different embodiments, and its several details may be modified in various obvious respects, all without departing from the scope of the invention. Accordingly, the drawings and description are to be regarded as illustrative in nature, and not as restrictive.

A more complete appreciation of the present invention and many of the attendant aspects thereof will be readily obtained as the same becomes better understood by reference to the following description when considered in connection with the accompanying drawings:
FIG 1 is a schematic representation of a DC power circuit showing components inside an Electric vehicle supply equipment (EVSE) for DC charging station, in accordance with one or more embodiments of the present invention;
FIG 2 is a schematic representation of an outgoing coil (OGC) of the DC power circuit, in accordance with one or more embodiments of the present invention;
FIG 3 is a schematic representation depicting safety risks associated with welded power contacts of the OGC in multiple DC-outlet EVSE;
FIG 4 is a schematic representation of a circuit for detection of welding state of an OGC using power converter voltage injection;
FIG 5 is a schematic representation of a circuit for detection of welding state of an OGC using low voltage inducer injection;
FIG 6 is a flowchart of a method for detecting a welded condition of power contacts in an OGC within the EVSE, in accordance with one or more embodiments of the present invention;
FIG 7 is a block diagram representation of a system for detecting a welded condition of power contacts in an OGC within the EVSE, in accordance with one or more embodiments of the present invention;
FIG 8 is a graphical representation of an observed voltage pattern by superimposing pulses by insulation monitoring device on power line to detect the welding condition of the power contacts in the OGC, in accordance with one or more embodiments of the present invention;
FIG 9 is a flowchart of process implemented by weld detection module for detecting the welded condition of power contacts in an OGC within the EVSE, in accordance with one or more embodiments of the present invention;
FIG 10 is a flowchart of process for voltage pattern type detection, in accordance with one or more embodiments of the present invention; and
FIG 11 is a graphical representation of results of weld detection when applied to voltage pattern, in accordance with one or more embodiments of the present invention.

Various embodiments are described with reference to the drawings, wherein like reference numerals are used to refer to like elements throughout. In the following description, for the purpose of explanation, numerous specific details are set forth in order to provide thorough understanding of one or more embodiments. It may be evident that such embodiments may be practiced without these specific details.

Examples of a method, a system, and a computer-program product for determining a welded condition of power contacts in an Outgoing Coil (OGC) within an Electric Vehicle Supply Equipment (EVSE)are disclosed herein. In the following description, for the purposes of explanation, numerous specific details are set forth in order to provide a thorough understanding of the embodiments of the invention. It is apparent, however, to one skilled in the art that the embodiments of the invention may be practiced without these specific details or with an equivalent arrangement. In other instances, well-known structures and devices are shown in block diagram form in order to avoid unnecessarily obscuring the embodiments of the invention.

Referring again to FIG 1, as discussed, an Outgoing Coil (OGC) refers to a type of high voltage DC contactor or relay used within the EVSE 102. Its primary function is to connect and disconnect the electrical power from the power converters 114 to the charging gun 116, which in turn charges the electric vehicle (EV) 104. The OGC plays a pivotal role in managing the flow of high-voltage direct current (DC) necessary for rapid charging processes. The term "welded condition" of the power contacts 110, 112 describes a scenario where the power contacts 110, 112 within the OGC, which should open and close to regulate the power flow, fail to open due to them being fused or stuck together. This welding usually results from excessive heat generated by high current passing through the contacts, often exacerbated by high voltages and the presence of arcing during operation. A welded state is hazardous as it may lead to uncontrollable power flow, posing safety risks such as overheating, fire, or damage to the electrical infrastructure and the vehicle being charged.

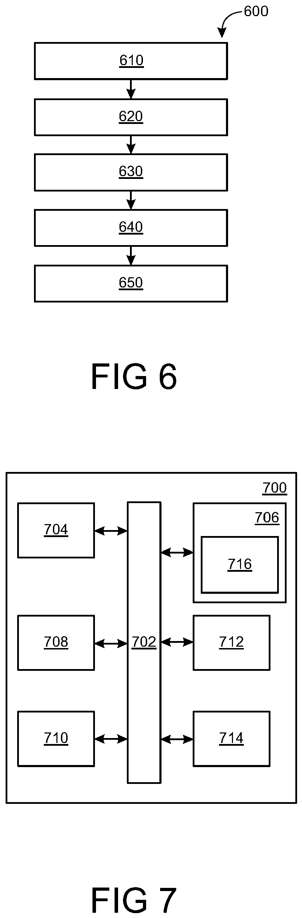

Referring to FIG 6, illustrated is a flowchart of a method (as represented by reference numeral 600) for determining the welded condition of the power contacts 110, 112 in the OGC within the EVSE 102, in accordance with an embodiment of the present invention. The method 600 is integral to ensuring the operational safety and reliability of EVSE systems, particularly in the context of providing electric power to vehicles. The method 600 of the present invention employs a combination of hardware monitoring and software algorithms to detect whether the power contacts 110, 112 within the OGC are in a welded condition. This detection allows for preventing potential hazards associated with welded contacts and for maintaining the overall health and functionality of the EVSE 102. The method 600 ensures that the welded state is identified and addressed promptly, enhancing the safety protocols and operational reliability of electric vehicle charging stations.

Referring to FIG 7, illustrated is a block diagram of a system 700 for determining the welded condition of the power contacts 110, 112 in the OGC within the EVSE 102, in accordance with one or more embodiments of the present invention. It may be appreciated that the system 700 described herein may be implemented in various forms of hardware, software, firmware, special purpose processors, or a combination thereof. One or more of the present embodiments may take a form of a computer program product comprising program modules accessible from computer-usable or computer-readable medium storing program code for use by or in connection with one or more computers, processors, or instruction execution system. For the purpose of this description, a computer-usable or computer-readable medium may be any apparatus that may contain, store, communicate, propagate, or transport the program for use by or in connection with the instruction execution system, apparatus, or device. The medium may be electronic, magnetic, optical, electromagnetic, infrared, or semiconductor system (or apparatus or device) or a propagation mediums in and of themselves as signal carriers are not included in the definition of physical computer-readable medium include a semiconductor or solid state memory, magnetic tape, a removable computer diskette, random access memory (RAM), a read only memory (ROM), a rigid magnetic disk and optical disk such as compact disk read-only memory (CD-ROM), compact disk read/write, and digital versatile disc (DVD). Both processors and program code for implementing each aspect of the technology may be centralized or distributed (or a combination thereof) as known to those skilled in the art.

In an example, the system 700 may be embodied as a computer-program product programmed for determining the welded condition of the power contacts 110, 112 in the OGC within the EVSE 102. The system 700 may be incorporated in one or more physical packages (e.g., chips). By way of example, a physical package includes an arrangement of one or more materials, components, and/or wires on a structural assembly (e.g., a baseboard) to provide one or more characteristics such as physical strength, conservation of size, and/or limitation of electrical interaction. It is contemplated that in certain embodiments the computing device may be implemented in a single chip. As illustrated, the system 700 includes a communication mechanism such as a bus 702 for passing information among the components of the system 700. The system 700 includes one or more processing units 704 and one or more memory units 706. Herein, the memory unit 706 is communicatively coupled to the processing unit 704. In an example, the memory unit 706 may be embodied as a computer readable medium on which program code sections of a computer program are saved, the program code sections being loadable into and/or executable in a system to make the system 700 execute the steps for performing the said purpose.

Generally, as used herein, the term "processing unit" refers to a computational element that is operable to respond to and processes instructions that drive the system 700. Optionally, the processing unit includes, but is not limited to, a microprocessor, a microcontroller, a complex instruction set computing (CISC) microprocessor, a reduced instruction set (RISC) microprocessor, a very long instruction word (VLIW) microprocessor, or any other type of processing circuit. Furthermore, the term "processing unit" may refer to one or more individual processors, processing devices and various elements associated with a processing device that may be shared by other processing devices. Additionally, the one or more individual processors, processing devices and elements are arranged in various architectures for responding to and processing the instructions that drive the system 700.

Herein, the memory unit 706 may be volatile memory and/or non-volatile memory. The memory unit 706 may be coupled for communication with the processing unit 704. The processing unit 704 may execute instructions and/or code stored in the memory unit 706. A variety of computer-readable storage media may be stored in and accessed from the memory unit 706. The memory unit 706 may include any suitable elements for storing data and machine-readable instructions, such as read only memory, random access memory, erasable programmable read only memory, electrically erasable programmable read only memory, a hard drive, a removable media drive for handling compact disks, digital video disks, diskettes, magnetic tape cartridges, memory cards, and the like.

In particular, the processing unit 704 has connectivity to the bus 702 to execute instructions and process information stored in the memory unit 706. The processing unit 704 may include one or more processing cores with each core configured to perform independently. A multi-core processor enables multiprocessing within a single physical package. Examples of a multi-core processor include two, four, eight, or greater numbers of processing cores. Alternatively, or in addition, the processing unit 704 may include one or more microprocessors configured in tandem via the bus 702 to enable independent execution of instructions, pipelining, and multithreading. The processing unit 704 may also be accompanied with one or more specialized components to perform certain processing functions and tasks such as one or more digital signal processors (DSP), and/or one or more application-specific integrated circuits (ASIC). Other specialized components to aid in performing the inventive functions described herein include one or more field programmable gate arrays (FPGA) (not shown), one or more controllers (not shown), or one or more other special-purpose computer chips.

The system 700 may further include an interface 708, such as a communication interface (with the said terms being interchangeably used) which may enable the system 700 to communicate with other systems for receiving and transmitting information. The communication interface 708 may include a medium (e.g., a communication channel) through which the system 700 communicates with other system. Examples of the communication interface 708 may include, but are not limited to, a communication channel in a computer cluster, a Local Area Communication channel (LAN), a cellular communication channel, a wireless sensor communication channel (WSN), a cloud communication channel, a Metropolitan Area Communication channel (MAN), and/or the Internet. Optionally, the communication interface 708 may include one or more of a wired connection, a wireless network, cellular networks such as 7G, 3G, 4G, 5G mobile networks, and a Zigbee connection.

The system 700 also includes a database 710. As used herein, the database 710 is an organized collection of structured data, typically stored in a computer system and designed to be easily accessed, managed, and updated. The database 710 may be in form of a central repository of information that may be queried, analysed, and processed to support various applications and business processes. In the system 700, the database 710 provides mechanisms for storing, retrieving, updating, and deleting data, and typically includes features such as data validation, security, backup and recovery, and data modelling.

The system 700 further includes an input device 712 and an output device 714. The input device 712 may take various forms depending on the specific application of the system 700. In an example, the input device 712 may include one or more of a keyboard, a mouse, a touchscreen display, a microphone, a camera, or any other hardware component that enables the user to interact with the system 700. Further, the output device 714 may be in the form of a display, a printer, a communication channel, or the like, without any limitations.

In the present system 700, the processing unit 704 and accompanying components have connectivity to the memory unit 706 via the bus 702. The memory unit 706 includes both dynamic memory (e.g., RAM, magnetic disk, writable optical disk, etc.) and static memory (e.g., ROM, CD-ROM, etc.) for storing executable instructions that when executed perform the method steps described herein for determining the welded condition of the power contacts 110, 112 in the OGC within the EVSE 102. In particular, the memory unit 706 includes a weld detection module 716 to perform steps for the said purpose.

Referring to FIGS 6-7 in combination, various steps of the method 600 (as described hereinafter), which may be executed in the system 700, or specifically in the processing unit 704 of the system 700, for automated digitization of schematic diagrams, are described. It may be appreciated that although the method 600 is illustrated and described as a sequence of steps, it may be contemplated that various embodiments of the method 600 may be performed in any order or different combinations and need not include all of the illustrated steps.

At step 610, the method 600 includes initiating a condition verification process in an EVSE controller based on a set of predefined conditions. That is, in an initial phase, the EVSE controller, such as the controller 212 (as shown in FIG 2) within the EVSE 102, activates a verification protocol designed to assess whether specific conditions conducive to safe and accurate testing are met. These predefined conditions ensure the integrity and reliability of subsequent diagnostic procedures. This verification process by the EVSE controller 212 serves as a preliminary check that establishes whether the conditions are appropriate for safely initiating the more detailed voltage pattern recognition and analysis processes that follow. If the conditions are not met, the method 600 pauses or delays further action until the necessary conditions are stabilized, ensuring that the DC power circuit 100 operates within safe operational parameters.

In the present embodiments, the set of predefined enabling conditions comprises one or more of an absence of an electric vehicle (EV) 104 connected to the EVSE 102, presence of an open command to the OGC, the insulation monitoring device 124 and the voltage transducer 122 being in a ready state. It may be understood that the readiness of the insulation monitoring device 124 ensures that it can accurately superimpose voltage pulses onto the power circuit, as required for the subsequent detection process (discussed later in more detail). Similarly, the readiness of the voltage transducer 122 allows to accurately capture the outlet voltage which may be influenced by the superimposed voltage pulses generated by the insulation monitoring device 124 (also discussed later in more detail). This readiness check helps prevent false readings of a true welded condition, which could lead to safety risks or damage to the EVSE 102 or the connected EV 104.

At step 620, the method 600 includes executing, by the EVSE controller 212, upon completion of the condition verification process, a voltage pattern recognition process to generate a voltage pattern by superimposing voltage pulses onto a power circuit of the EVSE 102 via the insulation monitoring device 124. That is, following the successful completion of the condition verification process in the EVSE controller 212, the method 600 includes executing a voltage pattern recognition process. This process is conducted by the EVSE controller 212, which activates the insulation monitoring device 124 to generate a specific voltage pattern by superimposing voltage pulses onto the power circuit of the EVSE 102. The insulation monitoring device 124, which is part of the EVSE 102, is used to impart voltage pulses that interact with the power circuit, thereby creating measurable electrical patterns across the power contacts 110, 112.

Herein, the voltage pattern is representative of an insulation state of the power contacts 110, 112. The insulation state is indicative of the electrical isolation or the lack thereof between conductive elements, which can signal potential issues such as short circuits or welded contacts. The pattern created by the superimposed pulses provides a reference of the current electrical properties of the power contacts 110, 112, revealing any abnormalities or deviations from expected insulation levels. By analysing this voltage pattern, the EVSE controller 212 may assess the functionality of the power contacts 110, 112. This assessment helps to determine whether the power contacts are operating normally, are experiencing insulation degradation, or are in a welded state that could compromise the safety of the EVSE 102.

In the present embodiments, the voltage pattern is generated by the insulation monitoring device 124 utilizing a DC superimposition principle on the power circuit. The insulation monitoring device 124 is specifically designed to detect variations in insulation resistance within the power circuit. By utilizing the DC superimposition principle, the insulation monitoring device 124 introduces controlled voltage pulses into the power circuit. These pulses interact with the electrical characteristics of the power circuit, including the power contacts 110, 112 and any connected loads or components. The response of the power circuit to these pulses provides data regarding the state insulation of the power circuit. Anomalies or deviations in this pattern can indicate issues such as a welded condition of the power contacts 110, 112.

In some embodiments, the method 600 includes, upon completion of the condition verification process, enabling a delay mechanism in the EVSE controller 212. Herein, the delay mechanism includes a timer that delays the voltage pattern recognition process, to allow for the stabilization of a power circuit state. This strategic step involves enabling the delay mechanism within the EVSE controller 212 that incorporates the timer to temporarily postpone the commencement of the voltage pattern recognition process, i.e., before further diagnostic procedures are carried out.

This intentional delay allows for the stabilization of the power circuit state, free from any transient fluctuations or disturbances that may have been present immediately after the initial checks or changes in the circuit conditions. Stabilizing the power circuit state is required for obtaining accurate and reliable measurements of the voltage patterns, as it reduces the misinterpretations caused by residual voltage variations that are not indicative of the true state of the power contacts.

At step 630, the method 600 includes capturing, by the voltage transducer 122, an outlet voltage influenced by the voltage pulses superimposed on the power circuit and transmitting the captured outlet voltage to the EVSE controller 212. That is, the method 600 includes capturing the outlet voltage influenced by the voltage pulses superimposed on the power circuit. This step is executed by the voltage transducer 122 which detects the variations in outlet voltage resulting from the voltage pulses generated by the insulation monitoring device 124. It may be understood that once the voltage pulses are superimposed onto the DC power circuit 100 by the insulation monitoring device 124, they alter the electrical characteristics of the circuit temporarily. The role of the voltage transducer 122 is to measure these changes. It captures the outlet voltage at various points, reflecting the immediate impact of the voltage pulses on the DC power circuit 100. This captured voltage represents the resultant electrical conditions within the circuit, particularly highlighting issues like a welded condition of the power contacts 110, 112.

At step 640, the method 600 includes determining, by the EVSE controller 212, a welding status of the power contacts 110, 112 based on the captured outlet voltage. Herein, after capturing outlet voltage data, the voltage transducer 122 transmits the captured outlet voltage back to the EVSE controller 212. This provides the controller with real-time data on electrical EVSE conditions following the pulse superimposition. The EVSE controller 212 uses this information to further analyse the state of the power contacts 110, 112 within the OGC, i.e., to determine whether the observed electrical patterns align with normal operation conditions or indicate a potential welded state.

The EVSE controller 212 uses algorithms designed to interpret the voltage patterns derived from the captured outlet voltage. If the voltage exceeds certain levels or shows anomalies consistent with known patterns of welded contacts, the EVSE controller 212 may determine that a welding condition may have occurred. Conversely, if the voltage levels fall within normal operating ranges, the EVSE controller 212 may determine that the power contacts 110, 112 are functioning correctly. In particular, once the outlet voltage has been transmitted to the EVSE controller 212, the EVSE controller 212 performs a detailed analysis involving comparing the captured outlet voltage against predefined threshold values that represent normal and abnormal electrical conditions. These thresholds help distinguish between a non-welded state and a potential welded state.

In the present embodiments, the method 600 includes determining, by the EVSE controller 212, a moving average value (MAV) of the outlet voltage based on the captured outlet voltage. That is, initially, the EVSE controller 212 calculates the MAV of the outlet voltage. This step is based on the outlet voltage data previously captured by the voltage transducer. The MAV is calculated by averaging the voltage values over a specified period or set of data points. This averaging process helps to smooth out short-term fluctuations in the voltage readings, providing a more stable and representative value of the ongoing electrical conditions within the DC power circuit 100. The method 600 further includes comparing, by the EVSE controller 212, the determined MAV of the outlet voltage against a first predefined threshold value. The first predefined threshold value is established based on typical operating conditions and safety standards relevant to the specific configuration and capabilities of the EVSE. By comparing the MAV to the first predefined threshold value, the EVSE controller 212 may effectively determine whether the averaged voltage level is within normal operating limits or if it exhibits potential signs of abnormal conditions such as a welded state.

Further, the method 600 includes comparing an instantaneous outlet voltage from the voltage transducer 122 against a second predefined threshold value. Instantaneous outlet voltage refers to the real-time voltage readings captured directly from the power circuit without averaging, reflecting the immediate electrical conditions. These readings are particularly useful for identifying sudden changes in the voltage pattern that might not be apparent from the MAV. The instantaneous outlet voltage, as measured by the voltage transducer, is compared against the second predefined threshold value. Herein, the second threshold value is higher than the first threshold value. The purpose of using a higher threshold for the instantaneous outlet voltage is to differentiate between regular fluctuations and significant voltage spikes that could indicate more severe issues, such as a welded contact condition. By setting a higher threshold for the instantaneous outlet voltage, the EVSE controller 212 can more reliably detect conditions where the voltage spikes abruptly, suggesting a potential welding of the power contacts 110, 112.

The method 600 further includes classifying, by the EVSE controller 212, the voltage pattern as one of abnormal, normal, or undefined. Herein, the voltage pattern is classified as the abnormal when either the computed MAV of the outlet voltage exceeds the first predefined threshold value, or the instantaneous outlet voltage exceeds the second predefined threshold value. When the voltage pattern is classified as abnormal, it indicates a likely issue with the power contacts 110, 112, such as a welded condition, suggesting that the power contacts 110, 112 may be presenting a potential safety hazard. The voltage pattern is classified as the normal when neither the computed MAV of the outlet voltage exceeds the first predefined threshold value, nor the instantaneous outlet voltage exceeds the second predefined threshold value. The normal classification indicates that the power contacts 110, 112 are functioning as intended, with no abnormalities affecting the EVSE 102 in the DC power circuit 100. Further, the voltage pattern is classified as the undefined when there is variation in capturing of the outlet voltage. This may occur due to inconsistencies in the voltage readings, for instance, resulting from transient noise, sensor errors, or other issues that prevent a clear determination. The undefined classification may lead to further investigation to determine the status of the power contacts 110, 112 more reliably. By classifying the voltage pattern into these categories, the EVSE controller 212 may effectively manage the operational status of the EVSE 102, ensuring that any potential issues are identified and addressed to maintain safety and efficiency in the charging process.

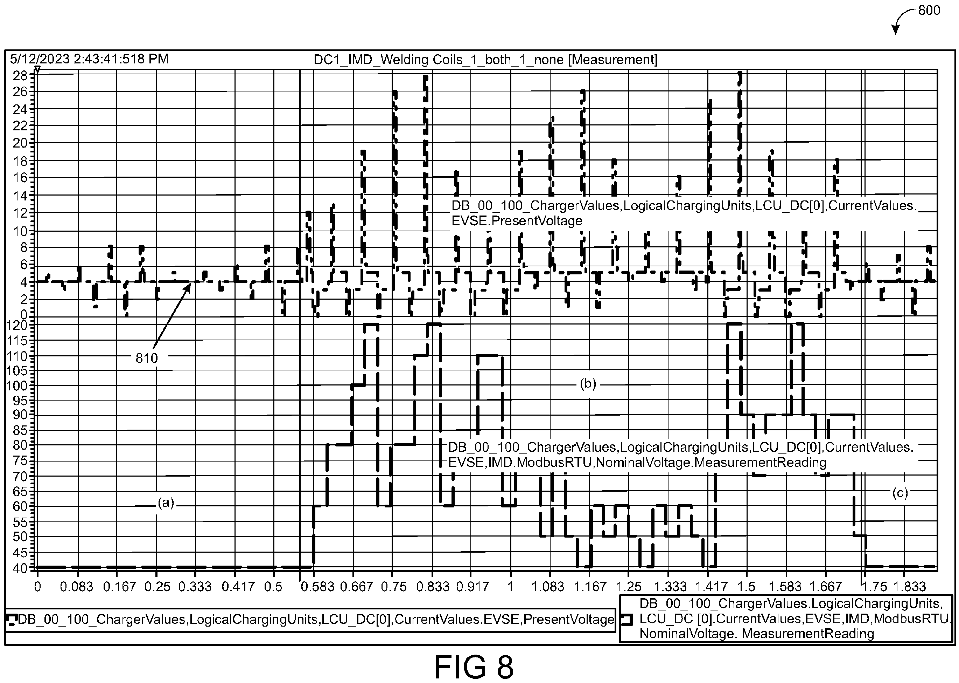

FIG 8 illustrates a graph 800 depicting voltage pattern observed with actual power contact welding. The graph 800 presents three distinct conditions captured during the testing process, which demonstrate the functionality and responsiveness of the insulation monitoring device 124 and the voltage transducer 122 within the EVSE 102. These conditions are labelled as sections (a), (b), and (c) within the graph 800. In the graph 800, a plot 810 provides the voltages measured by voltage transducer 122 with pulses from the insulation monitoring device 124 when charging is OFF, and the EV is disconnected.

The section (a) of the graph 800 illustrates the voltage pattern generated by the insulation monitoring device 124 and measured by the voltage transducer 122 when both the power contacts 110, 112 of the OGC within the DC+ and DC- power circuit are not welded, indicating they are in an open condition. This state represents the normal operation where no welding of the contacts has occurred, and the insulation between contacts is intact and functioning correctly.

The section (b) depicts a scenario where one or both of the power contacts within the DC+ and DC- circuits were deliberately forced to close by applying an external control voltage to the coil part of the OGC. In this condition, it is observed that the voltage pattern deviates significantly from the pattern seen in the section (a). This deviation is due to changes in the electrical characteristics of the power circuit, specifically the stray capacitances in the power converters 114. These capacitances charge and discharge as a result of the voltage pulses applied by the insulation monitoring device 124, illustrating how the power circuit behaves under fault conditions where the power contacts 110, 112 may be in a welded state.

The section (c) shows the condition where the external forcing of the power contacts 110, 112 into a closed state was removed, allowing the voltage pattern to return to its original state as depicted in the section (a). This recovery indicates the restoration of the voltage pattern to a normal condition, suggesting that the power contacts 110, 112 have returned to an unwelded, open state.

In some embodiments, the method 600 includes executing multiple instances of the voltage pattern recognition process. That is, after initiating the voltage pattern recognition process where voltage pulses are superimposed onto the power circuit via the insulation monitoring device 124 using the DC superimposition principle, the EVSE controller 212 captures and analyses the resulting voltage patterns multiple times. Each execution of this process generates new data on the state of the power contacts, helping to confirm initial findings of potential welding. This repetitive process ensures the accuracy and reliability of the welding status determination of the power contacts 110, 112 within the OGC. Herein, the welding status of the power contacts is confirmed based on consecutive instances of the voltage pattern recognition process exceeding a predefined count provide the voltage pattern being classified as the abnormal. That is, the method 600 provides that if the voltage pattern is classified as abnormal in a predefined number of consecutive instances, the welding status is positively identified as the welded condition. This predefined count serves as a statistical confirmation measure, enhancing the confidence in the outcome by reducing the probability of false positives or negatives that might occur from a single, isolated observation. Such execution of the voltage pattern recognition process multiple times and requiring consecutive abnormal classifications before confirming a welded status helps mitigate errors due to transient or sporadic disturbances in the power circuit.

These observations from the graph 800, specifically the voltage patterns observed under these various conditions, helps to determine the welding status of the power contacts 110, 112 in the OGC. It may be contemplated that that the behaviour of these voltage patterns, and thus the effectiveness of the method 600, depends significantly on the stray capacitances of the power converters 114, especially in the event of actual welding of the power contacts 110, 112. This dependency highlights capability of the method 600 to adaptively respond to real-world conditions within the power circuit of the EVSE 102.

At step 650, the method 600 includes controlling an operational state of an associated charging outlet of the EVSE 102 based on the determined welding status of the power contacts 110, 112 corresponding thereto. Once the welding status of the power contacts 110, 112 has been confirmed, whether it indicates a normal, abnormal, or undefined state, the EVSE controller 212 takes appropriate action to manage the operational state of the charging outlet linked to these power contacts 110, 112. If the welding status is determined to be abnormal, indicating a welded condition, the EVSE controller 212 may typically deactivate the associated charging outlet to prevent any potential safety hazards that could arise from continuing to supply power through welded contacts. This deactivation helps mitigate risks such as overheating, electrical fires, or damage to the vehicle and charging infrastructure. Conversely, if the welding status is determined to be normal, indicating that the power contacts 110, 112 are functioning correctly without any welding, the associated charging outlet remains operational, allowing normal charging activities to continue. This ensures that the charging infrastructure operates efficiently without unnecessary interruptions, providing reliable service to electric vehicle users. The ability of the EVSE controller 212 to control the operational state of the charging outlets based on the welding status of the power contacts 110, 112 ensures that only safe and fully functional charging points are active, thereby maintaining high standards of safety and reliability in electric vehicle charging stations.

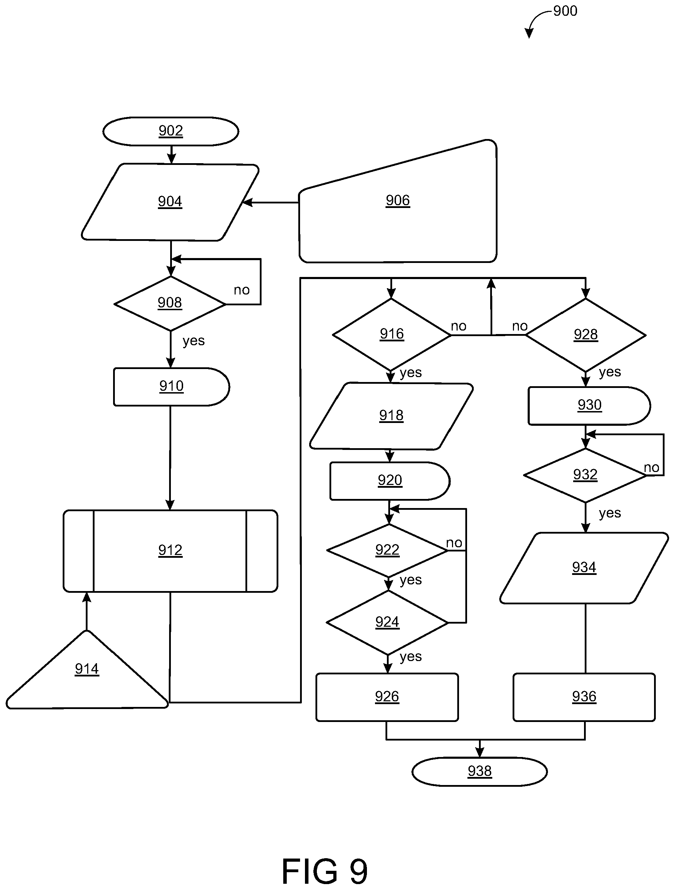

Referring now to FIG 9, illustrated is a flowchart of process (as represented by reference numeral 900) implemented by the weld detection module 716 for detecting the welded condition of the power contacts 110, 112 in the OGC within the EVSE 102, in accordance with one or more embodiments of the present invention. The process 900 provides a step-by-step representation of the algorithm to ensure accurate detection based on various conditions and criteria. At block 902, the process 900 begins. This initiation marks the start of the weld detection sequence managed by the EVSE controller 212. At block 904, the process 900 includes checking for conditions to enable weld detection. This check ensures that all necessary prerequisites are met before proceeding further in the detection process. The enabling conditions assessed include the absence of an electric vehicle (EV) connection to the outlet, ensuring that no charging process is currently taking place. At block 906, if the enabling conditions for weld detection are not met, the process 900 loops back to the start, continuously monitoring until such conditions are satisfied. This looping ensures constant readiness to initiate the weld detection procedure once all criteria are fulfilled. At block 908, once it is confirmed that the enabling conditions are met, the process 900 advances to block 910, where a monitoring delay is started. This delay allows for the stabilization of the power circuit state before any voltage pattern recognition processes begin. The delay ensures that any transient or temporary fluctuations are settled, providing a stable environment for accurate voltage monitoring and analysis.

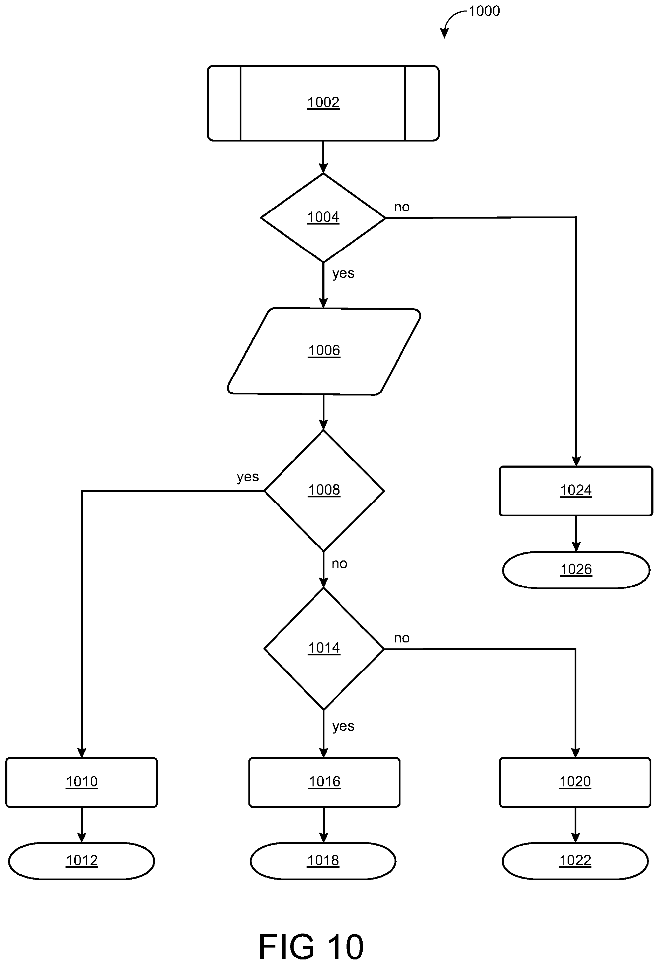

At block 912, the process includes performing a voltage pattern recognition algorithm. This algorithm analyses the voltage readings captured from the power circuit to determine any abnormalities that could indicate a welded state of the power contacts. The algorithm evaluates the voltage patterns based on the data provided by the insulation monitoring device 124 and the voltage transducer 122. FIG 10 illustrates a flowchart of a process (as represented by reference numeral 1000) for voltage pattern recognition utilized in the detection of welded conditions of the power contacts 110, 112 in the OGC within the EVSE 102. The process 1000 details the steps of the sub-algorithm designed to analyse the voltage patterns recorded from the power circuit of the EVSE 102. At block 1002, the process 1000 begins by executing the voltage pattern abnormality detection algorithm. At block 1004, the process 1000 checks if the condition for the delay enabling is completed. At block 1006, once the condition delay is confirmed to be done, the EVSE controller 212 computes the Moving Average Value (MAV) of the outlet voltage. Moving to block 1008, the process 100 involves comparing the MAV of the outlet voltage against a first predefined threshold value. This comparison helps determine whether the voltage levels are within normal operational limits or if there are signs of potential abnormalities that might suggest issues like a welded condition. If the MAV exceeds the threshold, as determined in the block 1008, the process 1000 continues to block 1010 where the voltage pattern is classified as abnormal, and then at block 1012, the process 1000 returns. This classification triggers further corrective actions within the EVSE 102 to address the potential welded condition. If the pattern does not exceed the threshold at block 1008, the process 1000 moves to block 1014 where it is checked if the instantaneous outlet voltage exceeds a second predefined threshold. If the instantaneous voltage does not exceed the second threshold at block 1014, the process 1000 moves to block 1020, where the voltage pattern is classified as normal. Conversely, if the instantaneous voltage exceeds the second threshold, as determined in block 1014, the process 1000 leads to block 1016, where the voltage pattern is once again classified as abnormal, and then at block 1012, the process 1000 returns. Further, if at the block 1004, the condition for the delay enabling is not completed, at block 1024, the voltage pattern is classified as undefined, and then at block 1026, the process 1000 returns.

Referring back to FIG 9, following the execution of the voltage pattern recognition algorithm, the process 900 moves to block 914, where the voltage transducer 122 reads the outlet voltage. This reading provides the data necessary for the EVSE controller 212 to analyse and compare against established threshold values for normal and abnormal conditions. At block 916, the process 900 involves checking if the voltage pattern is abnormal. If the voltage pattern does not exceed the predefined thresholds for abnormalities, the process 900 moves to block 928, where it checks if the pattern is normal. If at the block 916, the pattern is identified as abnormal, the process 900 proceeds to block 918 where it begins a count of the number of times an abnormal pattern is detected. This counting helps to confirm the consistency of the detected abnormalities, enhancing the reliability of the diagnosis. At block 920, there is a check to see if the monitoring delay is done. If the delay is not completed, the process 900 loops back to continue monitoring until the delay period is completed, as indicated by returning to block 922. Once the delay is completed, as confirmed at the block 922, and if the count of abnormal patterns exceeds a certain threshold, as checked at block 924, the process 900 then moves to block 926. Here, the power contacts weld detection is confirmed as true, indicating a definitive welded state.

After the check at the block 922, if the delay is completed and the count of abnormal patterns does not exceed the threshold as evaluated at the block 924, the process leads to block 934 where it is determined that the power contacts weld is not detected. This determination implies that, despite earlier indications of potential abnormalities, the cumulative evidence does not support a definitive diagnosis of a welded condition. At block 928, if the initial assessment finds the voltage pattern to be normal, which means neither the computed Moving Average Value (MAV) of the outlet voltage exceeds the first predefined threshold nor the instantaneous outlet voltage exceeds the second predefined threshold, the process also leads to block 934, confirming that the power contacts weld is not detected. In instances where the delay monitoring process is ongoing, as per block 930, the process 900 continues to evaluate the conditions, and the cycle may repeat as indicated by the loop back to block 932. This loop represents ongoing monitoring to ensure continued assessment of the voltage patterns over time. At the block 936, depending on the results from the blocks 924 or 934, the process 900 finalizes the detection status, establishing whether the power contacts 110, 112 are indeed welded or not. Finally, at block 938, the process 900 ends. This conclusion of the process 900 results in either the continuation of normal operations of the EVSE if no weld is detected or initiates appropriate safety protocols if a welded condition is confirmed.

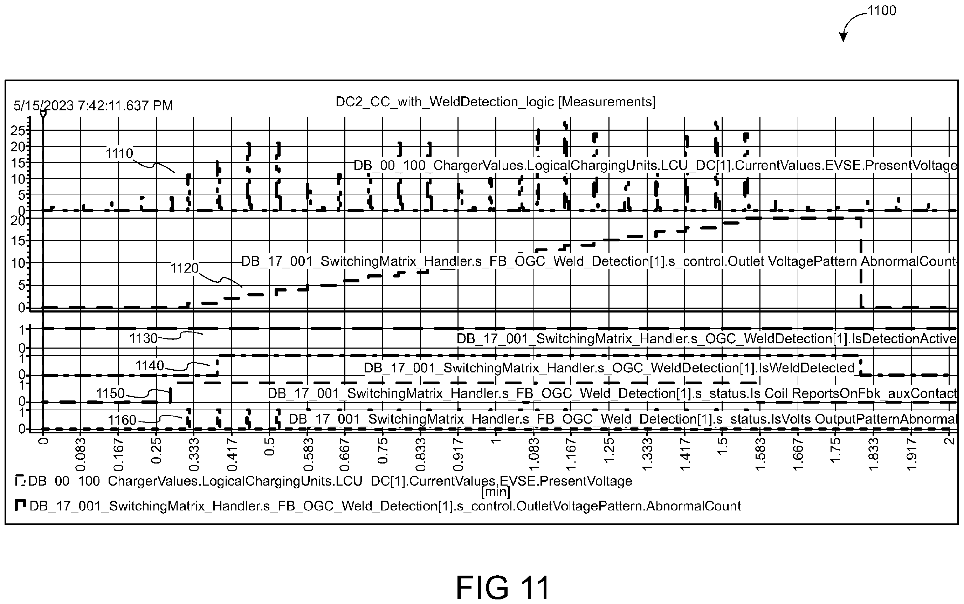

FIG 11 provides a graph 1100 of the results of the weld detection process when applied to the voltage pattern in the EVSE. The graph 1100 captures the trends from a test conducted using a set of the OGC equipped with an auxiliary/reed switch. For this test, a non-defective OGC was used to evaluate the effectiveness of the software-based algorithm, where the auxiliary switch accurately mirrored the state of the power contacts.

In the graph 1100, position 1110 indicates the voltage pattern generated and superimposed by the insulation monitoring device 124 on the power path of DC output for charging outlets. This voltage pattern is read by the higher-level controller 514 through the voltage transducer 122 located at the end of the outlet before the charging gun 118. This representation demonstrates the initial data capture which the algorithm uses to begin its analysis. Also, in the graph 1100, position 1120 illustrates the running count of abnormal voltage patterns detected by the software algorithm. This graph shows how the count is reset to zero when the weld of power contacts 110, 112 is no longer detected by the software, indicating a return to normal operating conditions.

Further, in the graph 1100, position 1160 displays the output of the sub-algorithm which determines whether the voltage pattern read from the voltage transducer 122 is found to be abnormal, with '1' indicating yes and '0' indicating no. This feedback allows the EVSE controller 212 to decide on the next steps in the operational management of the EVSE 102. Furthermore, in the graph 1100, position 1130 shows whether the software detection algorithm is active and monitoring the patterns. A value of '1' signifies active monitoring, which occurs when enabling conditions for detection are favourable and an additional delay has completed after these conditions are present. This delay allows sufficient time for the algorithm to make an accurate decision regarding potential welding of the power contacts 110, 112 of the OGC.

Moreover, in the graph 1100, position 1150 depicts the state of the power contacts 110, 112 as reported by the auxiliary/reed switch. Although this input is not required for the main algorithm, it is included as a reference marker for performance measurement. In this test, the auxiliary/reed switch was mirroring the states of the power contacts 110, 112 accurately, and when the value equals '1', it indicates that the OGC coil part was energized externally (when an open command was issued from the higher-level controller 514), thereby simulating the welding of the power contacts 110, 112. Further, in the graph 1100, position 1140 shows the output of the algorithm, which is the software-based deduction regarding the welded state of the power contacts 110, 112 based on the actual outlet voltage.

Thereby, the graph 1100 demonstrates that when an abnormal pattern emerges in the position 1110 and persists consistently after a few counts, the software sets the power contacts weld flag for the OGC to true. Conversely, when the pattern returns to normal, the weld detection flag is set to false.

The present invention provides a method 600 and a system 700 utilizing a software approach to accurately detect a welded (permanently closed) state of the power contacts 110, 112 of the OGC. This detection is facilitated by first classifying the voltage pulses, which are superimposed by the insulation monitoring device 124 into a high voltage DC power circuit, into categories of normal, abnormal, or undefined. These classifications are based on the voltage patterns read by the voltage transducer 122, which transmits the data to an analog to digital converter card within the existing controller. The classification of pulses as abnormal by the software algorithm is determined based on the peak value of the pulse and/or the difference between the peak value and the Moving Average Value (MAV) of the readings from the voltage transducer. If the conditions for software-based weld detection are favourable, which include the power circuit being in a de-energized state, and if several consecutive abnormal voltage pulses are detected within a specific timeframe (determined by the count of abnormal pulses detected within this period), a welded power contact of the OGC is detected. Upon detection, a visual indication is displayed on the charger, and the affected DC outlet is rendered out-of-order. Furthermore, the software algorithm disclosed is able to determine that the power contacts 110, 112 of the OGC are no longer in a welded state if the pulses are consistently classified as normal over a defined time interval. This feature allows for dynamic monitoring and management of the state of the power contacts 110, 112, ensuring the reliability and safety of the EVSE 102.

The system 700 of the present invention can be integrated into existing high-power DC fast conductive electric vehicle chargers, numbering over 1000, currently deployed in the field. This integration is facilitated through a remote over-the-air software firmware update, eliminating the need for any physical modifications or the addition of extra hardware components. The implementation leverages the existing hardware within the chargers, utilizing the interactions of these components to enable the new functionality. This is in contrast to traditional solutions, such as the low voltage injection technique, which necessitate complex hardware modifications and can introduce additional components into high-voltage circuits (up to 1000V). These changes often require extensive re-validation to assess their impact on insulation and potential electromagnetic interference or compatibility issues. In contrast, the software-based approach of the present invention does not involve any hardware alterations. Consequently, there is no need for external laboratory testing for re-validation or compliance with international standards such as those set by the International Electrotechnical Commission (IEC). This aspect significantly reduces potential costs associated with testing and compliance, ensuring that product pricing remains unaffected.

The reliability of weld detection is important in maintaining the operational integrity of electric vehicle chargers. A common issue with existing systems involves the auxiliary or reed switches of the OGCs, which do not reliably reflect the actual state of the power contacts. Often, these switches may become stuck in a closed position even when an open command has been issued to the coil part of the OGC. Over time, these switches may self-correct or "un-stick," leading to inconsistent performance. Such unreliability can lead to unnecessary requests for hardware replacements under warranty, presumed to be indicative of a significant charger failure. By accurately identifying true welded conditions without reliance on potentially faulty mechanical switches, the proposed solution can significantly reduce the frequency of unnecessary OGC replacements. This enhanced reliability of weld detection prevents unwarranted service calls and saves substantial costs associated with logistics and maintenance efforts. It is estimated that the correct assessment and avoidance of undue coil replacements could save approximately 100,000 Euros, considering the high costs associated with service personnel, logistics, and the downtime required at sites for replacing these coils.

Moreover, traditional weld detection methods often necessitate the availability and operational readiness of power converters or inducers, involving complex sequences that temporarily render the outlets unusable. These methods require starting and stopping power converters or inducers and switching the OGC, which blocks the outlets and delays subsequent charging sessions. The proposed software solution, in contrast, operates passively, analysing voltage patterns without needing additional hardware activation or the cycling of existing components. This approach allows for continuous availability of charging outlets, as no outlet needs to be blocked for the duration of the weld detection process.

Also, typically, third-party insulation monitoring devices are used to detect insulation resistance between DC+, DC-, and Protective Earth (PE). The proposed software solution repurposes the voltage pulses generated by these insulation monitors for an additional function-detecting the welding of power contacts in the OGC. This functionality is achieved by exploiting the inherent interactions between the pulses and the stray capacitances of the group of power converters, particularly when welding occurs in the normal off state of a DC outlet. Furthermore, traditional methods, typically require extra switching cycles (on-off) of the OGC to determine if the power contacts are welded, often involving high voltage injection. In contrast, the proposed solution operates without necessitating additional switching cycles and activates when an OFF/Open command is issued to the OGC after the completion of EV charging. This approach reduces unnecessary wear of the OGC and extends its operational lifespan by reducing the number of switching cycles, which are finite before maintenance and replacement are required.

Additionally, the proposed software-based solution provides an alternative probability check for weld detection, reducing reliance on the auxiliary or reed switches traditionally used with the OGCs. These switches are often unreliable due to manufacturing inconsistencies and may not accurately reflect the state of the power contacts. It is not uncommon for the auxiliary contacts to remain erroneously closed, suggesting a welded state when, in fact, the power contacts may be open. This discrepancy can lead to false alarms and erroneous indications of welding to the end-user, as flagged by the higher-level controller. By providing an alternative means of assessing the welding state, the proposed solution reduces the dependency on these auxiliary components, thereby enhancing the reliability of weld detection.

Furthermore, the implementation of this software-based solution enhances the overall availability of charging outlets. By ensuring more accurate detection of welding states and reducing false positives that typically lead to outlets being unnecessarily taken out of service, the system 700 minimizes downtime. This increase in operational reliability and decrease in service interruptions directly contribute to higher customer satisfaction, as users experience fewer disruptions and greater availability of charging services. The implementation of the proposed software-based solution also results in a significant reduction in the need for coil replacements, cost savings through decreased downtime, and the avoidance of unnecessary blocking of outlets during weld detection processes.

While the present invention has been described in detail with reference to certain embodiments, it should be appreciated that the present invention is not limited to those embodiments. In view of the present invention, many modifications and variations may be present themselves, to those skilled in the art without departing from the scope of the various embodiments of the present invention, as described herein. The scope of the present invention is, therefore, indicated by the following claims rather than by the foregoing description. All changes, modifications, and variations coming within the meaning and range of equivalency of the claims are to be considered within their scope.

**Reference Numerals**

| | |
|---|---|
| direct current (DC) power circuit | 100 |
| electric vehicle supply equipment (EVSE) | 102 |
| electric vehicle (EV) | 104 |
| first switch | 110 |
| second switch | 112 |
| power converter(s) | 114 |
| DC charging gun | 116 |
| electromagnetic interference (EMI) filters | 118 |
| EV batteries | 120 |
| voltage transducer | 122 |
| insulation monitoring device (IMD) | 124 |
| high voltage DC contactor | 200 |
| power part | 210 |
| EVSE controller | 212 |
| coil | 214 |
| hardwired interlock | 216 |
| reed switch | 218 |
| controller | 220 |
| outgoing coils (OGC) | 310 |
| power switching coil | 312 |
| power converters | 314 |
| electric vehicle | 316 |
| charging gun | 318 |
| additional controller | 400 |
| low voltage inducer | 510 |
| low voltage power supply | 512 |
| higher-level controller | 514 |
| method | 600 |
| step | 610 |
| step | 620 |
| step | 630 |
| step | 640 |
| step | 650 |
| system | 700 |
| bus | 702 |
| processing unit | 704 |
| memory unit | 706 |
| interface | 708 |
| database | 710 |
| input device | 712 |
| output device | 714 |
| weld detection module | 716 |
| graph | 800 |
| process | 900 |
| block | 902 |
| block | 904 |
| block | 906 |
| block | 908 |
| block | 910 |
| block | 912 |
| block | 914 |
| block | 916 |
| block | 918 |
| block | 920 |
| block | 922 |
| block | 924 |
| block | 926 |
| block | 928 |
| block | 930 |
| block | 932 |
| block | 934 |
| block | 936 |
| block | 938 |
| process | 1000 |
| block | 1002 |
| block | 1004 |
| block | 1006 |
| block | 1008 |
| block | 1010 |
| block | 1012 |
| block | 1014 |
| block | 1016 |
| block | 1018 |
| block | 1020 |
| block | 1022 |
| block | 1024 |
| block | 1026 |
| graph | 1100 |

## Claims

1. A method (600) for determining a welded condition of power contacts (110, 112) in an Outgoing Coil (OGC) within an Electric Vehicle Supply Equipment (EVSE) (102), the method (600) comprising:
initiating a condition verification process in an EVSE controller (212) based on a set of predefined conditions;
executing, by the EVSE controller (212), upon completion of the condition verification process, a voltage pattern recognition process to generate a voltage pattern by superimposing voltage pulses onto a power circuit of the EVSE (102) via an insulation monitoring device (124), wherein the voltage pattern is representative of an insulation state of the power contacts (110, 112);
capturing, by a voltage transducer (122), an outlet voltage influenced by the voltage pulses superimposed on the power circuit and transmitting the captured outlet voltage to the EVSE controller (212);
determining, by the EVSE controller (212), a welding status of the power contacts (110, 112) based on the captured outlet voltage; and
controlling an operational state of an associated charging outlet of the EVSE (102) based on the determined welding status of the power contacts (110, 112) corresponding thereto.

2. The method (600) according to claim 1 further comprising:
determining, by the EVSE controller (212), a moving average value (MAV) of the outlet voltage based on the captured outlet voltage; and
comparing, by the EVSE controller (212), the determined MAV of the outlet voltage against a first predefined threshold value.

3. The method (600) according to claim 2 further comprising comparing an instantaneous outlet voltage from the voltage transducer (122) against a second predefined threshold value, wherein the second threshold value is higher than the first threshold value.

4. The method (600) according to claim 3 further comprising:
classifying, by the EVSE controller (212), the voltage pattern as one of abnormal, normal, or undefined,
wherein:
the voltage pattern is classified as the abnormal when either the computed MAV of the outlet voltage exceeds the first predefined threshold value or the instantaneous outlet voltage exceeds the second predefined threshold value,
the voltage pattern is classified as the normal when neither the computed MAV of the outlet voltage exceeds the first predefined threshold value nor the instantaneous outlet voltage exceeds the second predefined threshold value, and
the voltage pattern is classified as the undefined when there is variation in capturing of the outlet voltage.

5. The method (600) according to claim 4 further comprising executing multiple instances of the voltage pattern recognition process, wherein the welding status of the power contacts (110, 112) is confirmed based on consecutive instances of the voltage pattern recognition process exceeding a predefined count provide the voltage pattern being classified as the abnormal.

6. The method (600) according to claim 1 further comprising, upon completion of the condition verification process, enabling a delay mechanism in the EVSE controller (212), the delay mechanism comprising a timer that delays the voltage pattern recognition process, to allow for the stabilization of a power circuit state.

7. The method (600) according to claim 1, wherein the set of predefined enabling conditions comprises one or more of an absence of an electric vehicle (EV) (104) connected to the EVSE (102), presence of an open command to the OGC, the insulation monitoring device (124) and the voltage transducer (122) being in a ready state.

8. The method (600) according to claim 1, wherein the voltage pattern is generated by the insulation monitoring device (124) utilizing a DC superimposition principle on the power circuit.

9. A system comprising:
one or more processing units (704); and
a memory unit (706) communicatively coupled to the one or more processing units (704), wherein the memory unit (706) comprises a weld detection module (716) stored in the form of machine-readable instructions executable by the one or more processing units (704), wherein the weld detection module (716) is configured to perform method (600) steps for detecting a welded condition of power contacts (110, 112) in an Outgoing Coil (OGC) within an Electric Vehicle Supply Equipment (EVSE) (102), according to any of the claims 1 to 8.

10. A computer-program product having machine-readable instructions stored therein, which when executed by one or more processing units, cause the one or more processing units to perform a method (600) according to any of the claims 1 to 8.
